# EUROPEAN PATENT APPLICATION

(11) **EP 3 301 569 A1**
(43) Date of publication of application: **04.04.2018**
(21) Application number: 17157107.8
(22) Date of filing: 21.02.2017
(51) Int. Cl.: G06F 9/44, G06F 9/45, G05B 19/05

(54) **PROGRAM DEVELOPMENT SUPPORTING APPARATUS, PROGRAM DEVELOPMENT SUPPORTING METHOD, AND PROGRAM DEVELOPMENT SUPPORTING PROGRAM**

(30) Priority: 30.09.2016 JP 2016194881
(71) Applicant: Omron Corporation, Kyoto 600-8530 (JP)
(72) Inventor: NAGAO, Kenjiro, Kyoto-shi, Kyoto 600-8530 (JP)
(74) Representative: Becker Kurig Straus

(57) **Abstract**

According to the invention, a ladder diagram program is stored with the data capacity suppressed. A program development supporting part 11 includes a calculation part 111 and a storage part 112. The storage part 112 stores a ladder diagram editing program 21 and a ladder diagram program that has been edited. The calculation part 111 executes the ladder diagram editing program 21 to edit the ladder diagram program and stores the ladder diagram program in the storage part 112. The calculation part 111 assigns two-dimensional coordinates to a ladder diagram represented by the ladder diagram program, detects two-dimensional coordinates and a type of a circuit element included in the ladder diagram and detects two-dimensional coordinates of a vertical connection line included in the ladder diagram, and stores the circuit element and the vertical connection line in association with the two-dimensional coordinates respectively in the storage part 112.

## Description

### CROSS-REFERENCE TO RELATED APPLICATION

This application claims the priority benefit of Japan application serial no. 2016-194881, filed on September 30, 2017. The entirety of the above-mentioned patent application is hereby incorporated by reference herein and made a part of this specification.

### BACKGROUND OF THE INVENTION

### Field of the Invention

The invention relates to a technique for storage of a ladder diagram program.

### Description of Related Art

Now, systems for automatically operating manufacturing lines, etc., through control over multiple devices (machines) with use of an industrial controller have been put to practical use in various fields. In such systems, the industrial controller controls multiple devices based on a ladder diagram program for automatic operation.

In this case, program developers create the ladder diagram program on a personal computer or the like, as disclosed in Patent Literature 1. Then, the program developers output the ladder diagram program from the personal computer or the like to the industrial controller.

### [Prior Art Literature]

### [Patent Literature]

Patent Literature 1: Japanese Patent Publication No. 2009-265750

### SUMMARY OF THE INVENTION

### Problem to be Solved

In the conventional configuration, however, all the elements of the ladder diagram program, such as circuit elements, horizontal connection lines, and vertical connection points, are handled as drawing materials. For this reason, the overall ladder diagram program occupies a large data capacity. In particular, the data capacity tends to increase significantly as the number of the circuit elements and connection lines increases and complicates the ladder diagram program.

Accordingly, the invention provides a technique for storage of the ladder diagram program, which is capable of suppressing the data capacity.

### Solution to the Problem

A program development supporting apparatus of the invention includes a calculation part and a storage part. The storage part stores a ladder diagram editing program and a ladder diagram program that has been edited. The calculation part executes the ladder diagram editing program to edit the ladder diagram program and stores the ladder diagram program in the storage part. The calculation part assigns two-dimensional coordinates to a ladder diagram. The calculation part detects two-dimensional coordinates and a type of a circuit element included in the ladder diagram and detects two-dimensional coordinates of a vertical connection line included in the ladder diagram. The calculation part stores the circuit element and the vertical connection line in association with the two-dimensional coordinates respectively in the storage part.

In this configuration, the position of the circuit element, the position and length of the vertical connection line, and the horizontal connection lines connected thereto in the ladder diagram are represented by the two-dimensional coordinates of the circuit element and the vertical connection line. Accordingly, if only the type of the circuit element and the two-dimensional coordinates of the circuit element and the vertical connection line are stored, the ladder diagram program is restored and the data capacity is suppressed as compared with the case of using drawing materials.

### Effects of the Invention

According to the invention, the ladder diagram program can be stored with the data capacity suppressed.

### BRIEF DESCRIPTION OF THE DRAWINGS

FIG. 1 is a schematic configuration diagram of the personal computer including the program development supporting apparatus according to an embodiment of the invention.
FIG. 2 is a diagram for illustrating the concept of the data format when the ladder diagram program is stored.
FIG. 3 is a diagram showing the original drawing of the ladder diagram program shown in FIG. 2.
FIG. 4 is a diagram showing an example of the data when the ladder diagram program is stored.
FIG. 5 is a flowchart showing the main flow of the ladder diagram storing method according to an embodiment of the invention.
FIG. 6 is a flowchart showing various detection processes for storing a more specific ladder diagram program.

### DESCRIPTION OF THE EMBODIMENTS

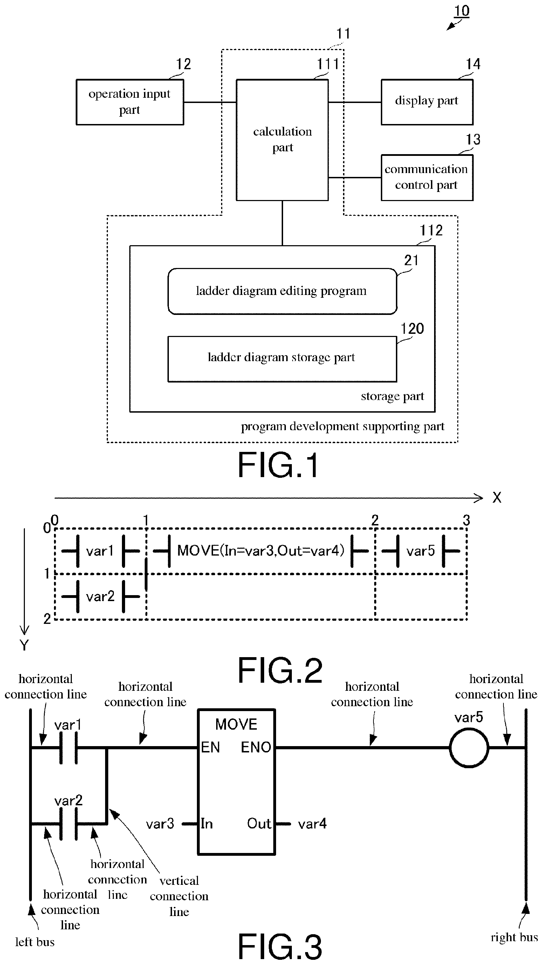

Techniques for program development support according to embodiments of the invention are described below with reference to the figures. FIG. 1 is a schematic configuration diagram of a personal computer including a program development supporting apparatus according to an embodiment of the invention.

As shown in FIG. 1, a personal computer 10 includes a program development supporting part 11, an operation input part 12, a communication control part 13, and a display part 14. The operation input part 12 is a mouse or a keyboard, and the display part 14 is a liquid crystal display, etc., for example. The communication control part 13 performs control over communication with an industrial controller. A ladder diagram program is outputted to the industrial controller (not shown) via the communication control part 13. The ladder diagram program is edited by the program development supporting part 11, stored in a predetermined data format, and outputted to the industrial controller in the data format.

The program development supporting part 11 corresponds to the program development supporting apparatus of the invention, and includes a calculation part 111 and a storage part 112. The storage part 112 stores various program groups including a ladder diagram editing program 21.

The calculation part 111 is composed of a CPU (Central Processing Unit), etc., for example, and executes the ladder diagram editing program 21 stored in the storage part 112. Thereby, a ladder diagram editing screen is displayed on the display part 14 for a program developer to edit the ladder diagram program with use of the operation input part 12. Upon accepting an operation input of storage (save) via the operation input part 12 during execution of the ladder diagram editing program 21, the calculation part 111 stores the edited ladder diagram program in a ladder diagram storage part 120 of the storage part 112. At this time, the ladder diagram program is stored in the predetermined data format obtained by using the following storing method.

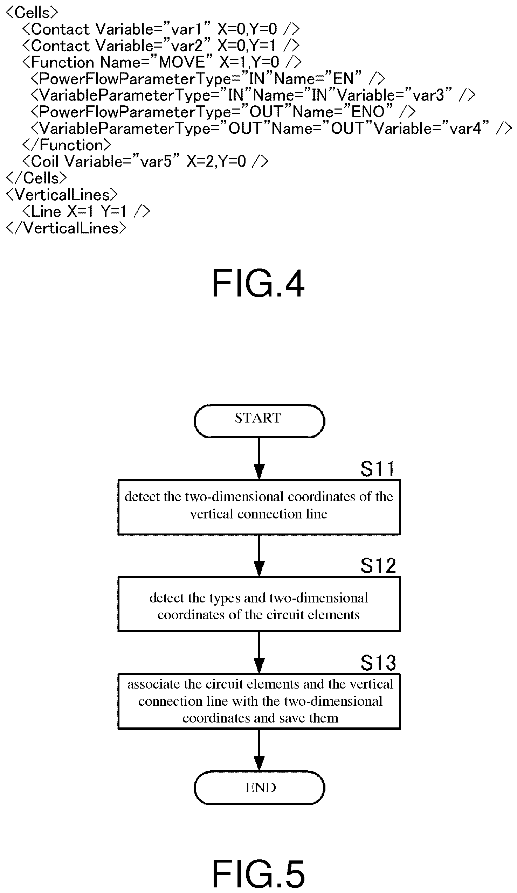

Next, the storing method of the ladder diagram program is described in more detail. FIG. 2 is a diagram for illustrating the concept of the data format when the ladder diagram program is stored. FIG. 3 is a diagram showing an original drawing of the ladder diagram program shown in FIG. 2. FIG. 4 is a diagram showing an example of the data when the ladder diagram program is stored.

First, although the configuration of the ladder diagram program is known, in order to explain the concept of storage of the ladder diagram program, the original drawing shown in FIG. 3 is described here as an example of the ladder diagram program. Nevertheless, FIG. 3 is merely an example and the configuration of the ladder diagram is not limited thereto.

As shown in FIG. 3, the ladder diagram includes a left bus and a right bus. The ladder diagram further includes circuit elements, horizontal connection lines, and a vertical connection line. The number of the circuit elements, the horizontal connection lines, and the vertical connection line is determined according to the content of the control to be achieved by the ladder diagram.

The circuit elements are disposed between the left bus and the right bus, and any of other circuit elements, the left bus, and the right bus is connected by using the horizontal connection lines and the vertical connection line. The connection determines the order of the control to be achieved by the ladder diagram. Moreover, the types of the circuit elements are determined by the shapes of the circuit elements.

In the case of FIG. 3, for example, the circuit elements (variables) var 1 and var 2 are contacts respectively and the circuit element (variable) var 5 is a coil. In addition, the circuit element (variable) represented by a rectangle is a function or a function block, and is a MOVE function in FIG. 3.

The left bus side of the circuit element (variable) var 1 is connected to the left bus via one horizontal connection line, and the right bus side of the circuit element (variable) var 1 is connected to an EN terminal of the MOVE function via one horizontal connection line. An ENO terminal of the MOVE function is connected to the circuit element (variable) var 5 via one horizontal connection line, and the right bus side of the circuit element (variable) var 5 is connected to the right bus via one horizontal connection line.

The circuit element (variable) var 2 is disposed on the lower side of the circuit element (variable) var 1. The left bus side of the circuit element (variable) var 2 is connected to the left bus via one horizontal connection line, and the right bus side of the circuit element (variable) var 2 is connected to the vertical connection line via one horizontal connection line.

The vertical connection line is connected to the right bus side of the circuit element (variable) var 1 and the right bus side of the circuit element (variable) var 2 via the horizontal connection lines respectively.

The circuit element (variable) var 3 is connected to an In terminal of the MOVE function, and the circuit element (variable) var 4 is connected to an Out terminal.

Next, the concept of storage of the ladder diagram program is described with reference to FIG. 2. As shown in FIG. 2, in the storing method of the ladder diagram program according to this embodiment, the left bus, the right bus, the circuit elements, the horizontal connection lines, and the vertical connection line of the ladder diagram are represented by two-dimensional coordinates. Specifically, the horizontal direction of the ladder diagram is set as an X axis direction and the position of the left bus in the ladder diagram is set to X = 0. Thus, the value of X increases as it gets closer to the right bus. At this time, the value of X is sequentially added every time the circuit element is detected.

In addition, as shown in FIG. 2, the vertical direction of the ladder diagram is set as a Y axis direction. The uppermost segment is set to Y = 0 and the value of Y sequentially increases toward the lower segment.

Thus, as shown in FIG. 2, the coordinates of the circuit element (variable) var 1 are (X, Y) = (0, 0), the coordinates of the MOVE function are (X, Y) = (1, 0), and the coordinates of the circuit element (variable) var 5 are (X, Y) = (2, 0). Besides, the coordinates of the circuit element (variable) var 2 are (X, Y) = (0, 1).

Furthermore, for the coordinates of the vertical connection line, the coordinates of the arrangement position on the two-dimensional coordinates are specified and become (X, Y) = (1, 1) in the case of FIG. 2.

Then, in the storing method of the ladder diagram program according to this embodiment, the X coordinate of the left bus is defined as "0," and the name (var 1, etc.) of the circuit element (variable) and the coordinates of the circuit element (variable) are stored in association with each other. Moreover, the type (contact, etc.) of the circuit element (variable) is also stored in association with the name (var 1, etc.) of the circuit element (variable) and the coordinates of the circuit element (variable).

Specifically, in the case of the ladder diagram of FIG. 3, the data format is as shown in FIG. 4. As shown in FIG. 4, in the storing method of the ladder diagram program according to this embodiment, the ladder diagram program is stored based on text data, for example. As shown in FIG. 4, the name of the circuit element (variable), the type of the circuit element (variable), and the coordinates are recorded in association in the text data.

Specifically, in the case where the circuit elements are contacts, coils, etc., the name of the circuit element (variable), the type of the circuit element (variable), and the coordinates are collectively recorded in a line.

For example, in <Contact Variable="var1" X=0,Y=0 />, it is recorded that the circuit element (variable) is var 1, the type of the circuit element (variable) is contact, and the coordinates are (X, Y) = (0, 0).

In <Contact Variable="var2" X=0,Y=1 />, it is recorded that the circuit element (variable) is var 2, the type of the circuit element (variable) is contact, and the coordinates are (X, Y) = (0, 1).

In <Coil Variable="var5" X=2, Y=0 />, it is recorded that the circuit element (variable) is var 5, the type of the circuit element (variable) is a coil, and the coordinates are (X, Y) = (2, 0).

In the case of the function or the function block, the name and coordinates of the function or the function block are collectively recorded in a line, and in the subsequent line, the name of each terminal and the connection target are recorded sequentially for each terminal respectively.

For example, in <Function Name="MOVE" X=1, Y=0 />, it is recorded that the circuit element is the "MOVE" function and the coordinates are (X, Y) = (1, 0).

Moreover, in <PowerFlowParameterType="IN"Name="EN" />, it is recorded that the terminal connected to the horizontal connection line on the left bus side of the function is the input terminal and the terminal name is "EN."

In <VariableParameterType="IN"Name="IN"Variable="var3" />, it is recorded that the function has the input terminal from another circuit element (variable), the terminal name is "IN," and it is connected to the circuit element (variable) var 3.

In <PowerFlowParameterType="OUT"Name="ENO" />, it is recorded that the terminal connected to the horizontal connection line on the right bus side of the function is the output terminal and the terminal name is "ENO."

In <VariableParameterType="OUT"Name="OUT"Variable="var4" />, it is recorded that the function has the output terminal to another circuit element (variable), the terminal name is "OUT," and it is connected to the circuit element (variable) var 4.

In the case of the vertical connection line, in <Line X=1 Y=1 />, the vertical connection line is disposed at the coordinates (X, Y) = (1, 1).

Through storage in the text data in this manner, the storage capacity can be suppressed, as compared with the conventional technique which stores each element that has been drawn as a ladder diagram as a drawing material respectively.

Then, as shown in FIG. 2, in the ladder diagram, each circuit element is two-dimensionally arranged with reference to the uppermost position of the left bus, and each circuit element is stored in association with the coordinates thereof. Therefore, when the text data as shown in FIG. 4 is used, the ladder diagram program as shown in FIG. 3 can be easily restored.

Further, in the method described above, the circuit elements (variables) connected to the function or the function block are recorded as accessory elements of the function or the function block. Accordingly, in comparison with separately detecting these circuit elements (variables) and acquiring the two-dimensional coordinates to provide individual lines for these circuit elements (variables), the method of the invention can reduce the data capacity.

FIG. 5 illustrates the processes described above in a flowchart. The flowchart of FIG. 5 shows the main flow of the ladder diagram program storing method according to an embodiment of the invention.

As shown in FIG. 5, in Step S11, the program development supporting part 11 detects the vertical connection line from the edited ladder diagram program and detects the two-dimensional coordinates of the vertical connection line. Regarding the detection of the vertical connection line, because which part of the ladder diagram is the vertical connection line has been stored when the ladder diagram program is edited, it may be used. Then, by setting the X axis and the Y axis with the uppermost position of the left bus of the ladder diagram as the origin, as described above, the two-dimensional coordinates can be easily detected. At this time, the horizontal connection lines are also detected in the same manner as the vertical connection line.

Next, in Step S12, the program development supporting part 11 detects the circuit elements (variables) and detects the types and the two-dimensional coordinates thereof. Regarding the detection of the circuit elements (variables) and the types, like the vertical connection line and the horizontal connection lines, which part of the ladder diagram is the circuit element (variable) has been stored when the ladder diagram program is edited, and the type of the circuit element (variable) has been associated. Therefore, it may be used. Then, by setting the X axis and the Y axis with the uppermost position of the left bus of the ladder diagram as the origin, as described above, the two-dimensional coordinates can be easily detected.

The detection of the vertical connection line and the horizontal connection lines and the detection of the circuit elements (variables) are not necessarily performed in this order and may be performed at the same time.

Thereafter, in Step S13, the program development supporting part 11 associates the circuit elements (variables) and the vertical connection line with these two-dimensional coordinates and stores them. At this time, as described above, the stored data is realized by the text data format that is small in capacity. Thereby, the ladder diagram program is stored with a small capacity.

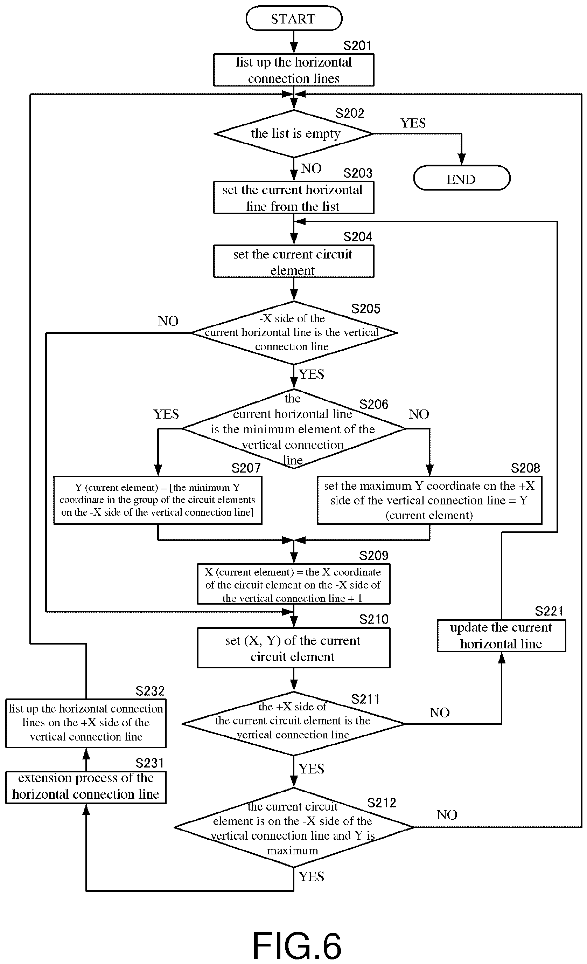

The method for detection of the circuit elements (variables), the types thereof, and the two-dimensional coordinates is described more specifically hereinafter. FIG. 6 is a flowchart showing various detection processes for storing a more specific ladder diagram program.

In Step S201, the program development supporting part 11 detects the horizontal connection lines from the ladder diagram and lists up the horizontal connection lines. At this time, the program development supporting part 11 lists up the horizontal connection lines that are connected to the left bus sequentially from the upper side to the lower side of the ladder diagram.

In Step S202, when detecting that the list of the horizontal connection lines is not empty (S202: NO), the program development supporting part 11 moves on to Step S203.

In Step S203, the program development supporting part 11 sets the horizontal connection line at the beginning (first) of the list as a current horizontal line.

In Step S204, the program development supporting part 11 detects the circuit element that is connected to the right bus side (+X side) of the current horizontal line and sets the circuit element as a current circuit element.

In Step S205, if the program development supporting part 11 detects that the left bus side (-X side) of the current horizontal line is connected to the vertical connection line (S205: YES), the program development supporting part 11 moves on to Step S206. On the other hand, if the program development supporting part 11 detects that the left bus side (-X side) of the current horizontal line is not connected to the vertical connection line (S205: NO), the program development supporting part 11 moves on to Step S210.

In Step S206, the program development supporting part 11 detects whether the current horizontal line is the minimum element of the vertical connection line. If the program development supporting part 11 detects that the current horizontal line is the minimum element of the vertical connection line (S206: YES), the program development supporting part 11 moves on to Step S207. On the other hand, if the program development supporting part 11 detects that the current horizontal line is not the minimum element of the vertical connection line (S206: NO), the program development supporting part 11 moves on to Step S208.

In Step S207, the program development supporting part 11 sets Y (current element), which is the Y coordinate of the current circuit element (variable), to the minimum Y coordinate in the group of the circuit elements (variables) on the -X side of the vertical connection line. On the other hand, in Step S208, the program development supporting part 11 sets Y (current element) to the maximum Y coordinate in the group of the circuit elements (variables) on the +X side of the vertical connection line. By performing Steps S207 and S208, the Y coordinate of the circuit element (variable) that is connected to the vertical connection line on the left bus side (-X side) is determined.

In Step S209, the program development supporting part 11 sets the X coordinate of the current circuit element (variable), which is X (current element), to a value obtained by adding "1" to the X coordinate of the circuit element (variable) on the left bus side (-X side) of the vertical connection line. By performing Step S209, the X coordinate of the circuit element (variable) that is connected to the vertical connection line on the left bus side (-X side) is determined.

In Step S210, the program development supporting part 11 sets the two-dimensional coordinates (X, Y) of the current circuit element (variable), which is connected to the vertical connection line on the left bus side (-X side), to (X (current element), Y (current element)) that have been determined in Step S207 or Step S208 and Step S209. Further, the program development supporting part 11 sets the two-dimensional coordinates (X, Y) of the current circuit element (variable), which is connected to the vertical connection line on the left bus side (-X side), to the value obtained by adding "1" to the X coordinate of the circuit element (variable) adjacent to the left bus side (-X side) of the current circuit element (variable), and the Y coordinate of the circuit element (variable) adjacent to the left bus side (-X side) of the current circuit element (variable).

In Step S211, the program development supporting part 11 detects whether the right bus side (+X side) of the current circuit element (variable) is connected to the vertical connection line. If the right bus side (+X side) of the current circuit element (variable) is connected to the vertical connection line (S211: YES), the program development supporting part 11 moves on to Step S212. If the right bus side (+X side) of the current circuit element (variable) is not connected to the vertical connection line (S211: NO), the program development supporting part 11 moves on to Step S221.

In Step S212, if the program development supporting part 11 detects that the current circuit element (variable) is on the left bus side (-X side) of the vertical connection line and the Y coordinate is maximum in the group of the circuit elements (variables) connected to the vertical connection line on the left bus side (-X side) (S212: YES), the program development supporting part 11 moves on to Step S231. On the other hand, if the program development supporting part 11 detects that the current circuit element (variable) is on the left bus side (-X side) of the vertical connection line and the Y coordinate is not maximum in the group of the circuit elements (variables) connected to the vertical connection line on the left bus side (-X side) (S212: NO), the program development supporting part 11 moves on to Step S202.

In Step S221, the program development supporting part 11 updates the current horizontal line. Specifically, the program development supporting part 11 sets the horizontal connection line on the right bus side (+X side) of the current circuit element (variable) as a new current horizontal line. After updating the current horizontal line, the program development supporting part 11 returns to Step S204.

In Step S231, the program development supporting part 11 performs an extension process of the horizontal connection line and moves on to Step S232. In Step S232, the program development supporting part 11 lists up the horizontal connection lines on the right bus side (+X side) of the vertical connection line and moves on to Step S202.

The process described above is repeated, and when the program development supporting part 11 detects that the list is empty (S202: YES), the process ends.

By performing the process, the two-dimensional coordinates of the circuit element (variable) can be detected reliably.

## Claims

1. A program development supporting apparatus, comprising:
a storage part (112) storing a ladder diagram editing program (21) and storing a ladder diagram program that has been edited; and
a calculation part (111) executing the ladder diagram editing program (21) to edit the ladder diagram program and storing the ladder diagram program in the storage part (112),
wherein the calculation part (111) assigns two-dimensional coordinates to a ladder diagram represented by the ladder diagram program,
detects a vertical connection line included in the ladder diagram and two-dimensional coordinates of the vertical connection line, and a circuit element, two-dimensional coordinates and a type of the circuit element, and
stores the circuit element and the vertical connection line in association with the two-dimensional coordinates respectively in the storage part.

2. The program development supporting apparatus according to claim 1, wherein when detecting that the circuit element is a function or a function block, the calculation part (111) stores a circuit element connected to the function or the function block together with a connection relationship with respect to the function or the function block.

3. A program development supporting method for editing a ladder diagram program and storing the ladder diagram program that has been edited, the program development supporting method comprising:
assigning two-dimensional coordinates to a ladder diagram represented by the ladder diagram program;
detecting a vertical connection line included in the ladder diagram and two-dimensional coordinates of the vertical connection line, and a circuit element, two-dimensional coordinates and a type of the circuit element; and
storing the circuit element and the vertical connection line in association with the two-dimensional coordinates respectively.

4. A program development supporting program, enabling a computer (10) to execute a process of editing a ladder diagram program and storing the ladder diagram program that has been edited, wherein the program development supporting program enables the computer (10) to execute:
a process of assigning two-dimensional coordinates to a ladder diagram represented by the ladder diagram program;
a process of detecting a vertical connection line included in the ladder diagram and two-dimensional coordinates of the vertical connection line, and a circuit element, two-dimensional coordinates and a type of the circuit element; and
a process of storing the circuit element and the vertical connection line in association with the two-dimensional coordinates respectively.
